Europäisches Patentamt

European Patent Office

Office européen des brevets

(11) Publication number: **0 023 149**
**A1**

## (12) EUROPEAN PATENT APPLICATION

(21) Application number: 80302464.5

(22) Date of filing: 21.07.80

(51) Int. Cl.³: **C 23 C 13/06**
**G 02 B 1/10, C 03 C 17/00**

(30) Priority: **19.07.79 GB 7925228**

(43) Date of publication of application:
28.01.81 Bulletin 81/4

(84) Designated Contracting States:
AT BE CH DE FR GB IT LI LU NL SE

(71) Applicant: **OPTICAL & ELECTRICAL COATINGS
LIMITED
Industrial Estate
Totnes Devon TQ9 5JA(GB)**

(72) Inventor: **Elsworth, Robin Antony
Littlehempston
Near Totnes Devon(GB)**

(74) Representative: **Moore, Anthony John et al,
Gee & Co., Chancery House, Chancery Lane,
London WC2A 1QU(GB)**

(54) Method of producing a coating of non uniform thickness or density by vacuum deposition and apparatus therefor.

(57) An optical coating is produced on the undersurface of a glass substrate (19) held in a jig (10) rotated within a vacuum-deposition chamber, except in an area bounded by line (27) and an end plate (16) which is permanently masked. Rotation of the jig (10) causes sinusoidal reciprocation of a cam follower (26) and an associated masking blade (23) positioned close to the undersurface of the substrate (19), a medial band of which between lines (27) and (28) is thus masked for a period which decreases linearly with distance from the line (28). Material is deposited on the unmasked major portion of the undersurface of the substrate (19) to form a uniform coating and on the differentially masked band to form a graded coating, the density of which decreases linearly to zero at the line (27).

FIG 1

- 1 -

## VACUUM-DEPOSITION OF COATINGS ONTO SUBSTRATES

This invention relates to a method of, and apparatus for, producing on a substrate a vacuum-deposited coating having a non-uniform thickness or density; such coatings are sometimes subsequently referred to as "graded coatings" and find particular, but not exclusive, application in remedying a defect of known dual combiners.

A combiner is a device used in for example an aircraft and consists essentially of an inclined plate of glass positioned in the line of a pilot's vision so that he can both see through it and also see, reflected from the nearer surface of the plate which is coated with a reflectance (beam-splitting) coating, light projected onto the nearer surface. By means of the virtual image thus created information can be presented to the pilot. If the density of information which can be achieved with a single plate of glass is inadequate, as for example in sophisticated fighter aircraft, a second glass plate is used which extends behind only the upper portion of the main plate. Such a combiner is known as a dual combiner. Because the light reflected from the surface of the second plate has to pass through the upper portion of the main plate, the reflectance of the coating on the upper plate is increased so as to be greater than that on the lower portion of the main plate, the upper part of which has an anti-reflectance coating. As there is an abrupt change in the transmittance of a dual combiner at the lower edge of the second plate due to the change from a single thickness of glass plate to a double thickness and to the difference in the reflectance of the coatings, an artificial horizon is created at this lower edge. Such an artificial horizon can clearly lead to pilot error and it has been proposed to overcome the illusion of an artificial horizon by providing at the lower marginal edge portion of the second plate a band of coating whose reflectance decreases to zero at the lower edge itself. The corresponding band on the main plate has a coating of decreasing density so that its reflectance decreases to zero at the upper boundary of the band.

Previously graded coatings have been produced by inclining the substrate to a plane normal to the direction of the evaporation source. However this method tends to produce coatings which are irregular due to the difference in the length of the paths which have to be covered by the evaporated material. The present invention enables graded coatings constituting such bands of varying density as are mentioned above to be produced accurately and economically.

According to the present invention there is provided a method of producing on a surface of a substrate a vacuum-deposited coating of non-uniform thickness or density characterised in that the period for which said surface is exposed to evaporated material at any particular point is varied depending on the density or thickness of the coating desired at said point.

- 3 -

Variation of the exposure time of one part of said
surface relative to another part of said surface
may be achieved by the use of a mask and substrate
which are relatively moveable.  It is preferred from
a practical viewpoint to arrange for the mask to be
moveable and to hold the substrate stationary, and
to use a reciprocating movement where the thickness
is to vary with perpendicular distance from a baseline;  however a rotary movement, preferably with a
rotating mask having a suitable profile and/or apertures, may be more suitably employed if the thickness
is to vary radially from a given point.

Depending on the pattern of relative movement of the
mask and substrate the difference in thickness of
the coating of one part of said surface with respect
to another part may be varied continuously or discontinuously.

To obtain the maximum uniformity in the coating of
any part or contour of given thickness, it is necessary to expose the substrate for a number of short
periods which together total the exposure time necessary to give the requisite coating thickness.

According to the present invention there is also provided apparatus for controlling the thickness or
density of a coating being produced on the surface of
a substrate by vacuum-deposition characterised in that
said apparatus comprises drive means for imparting
relative movement between holding means for holding
said substrate and masking means. Where reciprocal

- 4 -

movement is employed the drive means preferably comprise a cam arranged to urge the mask in one direction, and resilient means which act to return the mask in the opposite direction. Where a cam is employed the speed of said relative movement is clearly governed by the choice of the cam profile. Where this is sinusoidal the variation of coating thickness in the direction of reciprocation will be linear; other cam profiles may be employed if non-linear variation is desired.

Where an outer edge of the mask forms its effective edge, the edge may be a curved or rectlinear; when a mask with a slit is employed the speed of relative movement is necessarily non-uniform if a graded coating is to be achieved.

Preferably the substrate is mounted on a jig which is arranged for rotation within a vacuum-deposition chamber about a stationary cam and which has a carriage mounted for reciprocation thereon. As the carriage is rotated about the cam the carriage is moved radially outwards when the radial dimension of the cam surface is increasing and is moved radially inwards by the action of tension springs when the radial dimension of the cam profile is decreasing.

An embodiment of the invention will now be described, by way of example only, with reference to the accompanying drawing in which

Figure 1 is a plan of apparatus according to the invention for producing graded coatings;

and Figure 2 is a section on line A-A of
Figure 1.

A jig 10 as shown in the Figures is hung from a
rotary drive member 11 mounted on the lid 12 of a
conventional vacuum-deposition chamber by four
pillars 13, each pair of which terminates in a crossmember 14.  The two cross-members 14 themselves
support a pair of parallel carriage tracks 15 which
terminate in end plates 16 and are each provided
with a longitudinal V-shaped groove in their upper
surfaces for reception of bearing balls 17 and at
their inner lower edges with a lip 18 for supporting
a workpiece 19.  Supported above each of the respective tracks 16 by the balls 17 is an inverted L-section carriage guide 20, the guides 20 being bridged
by a transverse member 21 which is connected to the
nearer of the two cross-members 14 by two tension
springs 22;  the bottom edges of the carriage guides
20 are connected by a blade 23 which constitutes a
moving mask.

A fixed cam 24 having a sinusoidal profile is suspended from a stationary central portion of the lid
12 of the chamber by two pillars 25 and engaged by
a cam follower 26 mounted on the transverse member 21.

To cover a glass plate with a reflective coating
which reduces in thickness to zero across a marginal
band of the coating, a rectangular glass plate constituting the workpiece 19 is placed in the jig 10
with its edges resting on the lips 18.

The underside of the plate 19 between a line 27, coincident with the radially inner edge of the transverse member 21, and the edge adjacent the endplate 16, is permanently masked. The lid 11 is then closed and vacuum-deposition of a reflectance coating effected in the conventional way with, for example, TiO being evaporated in oxygen to give a $TiO_2$ coating. During deposition the jig 10 revolves several hundred times and the main, radially inner area of the undersurface of the plate 19 terminating at a chain-dot line 28 receives an even coating in the normal way. However, a marginal band between the lines 27 and 28 is masked to a greater or lesser extent by the blade 23 and receives a graded coating in the following manner.

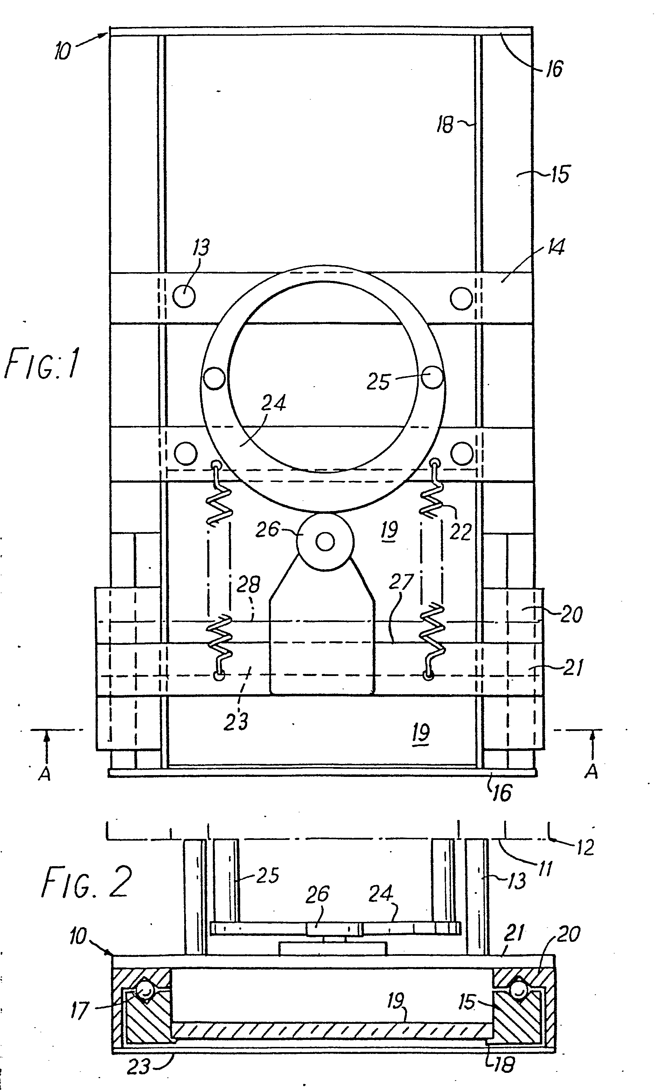

It will be noted that in Figure 1 the carriage guides 20 have been urged to the radially outward extent of their reciprocal movement by the action of the cam 24. In this position the radially inner edge of the mask blade 23 is at the line 27. The inward limit of travel of the edge of the blade 23 is of course at the chain-dot line 28.

As the jig 10 revolves during coating the mask blade 23 is caused to reciprocate, masking the marginal band for a time which is at a maximum adjacent to the line 27 and at a minimum adjacent the line 28. At the marginal band the plate 19 thus receives a coating having a thickness which decreases linearly from a maximum at the line 28 to zero at the line 27. The plate 19 is then provided with a conventional anti-reflectance coating on the previously masked area of the coated surface and on its entire opposite surface. The above coating procedures are suitable for coating the main plate 19 of a dual combiner. A second, smaller plate can be coated in a similar way with the reflectance area terminating in a band of graded coating extending across a marginal edge portion of the plate, such that when the two plates are assembled the two bands of graded coating are in register and their thicknesses decrease in opposite directions. The opposite surface of the second plate is coated with a conventional anti-reflectance coating.

- 1 -

Claims:

1.    A method of producing on a surface of a substrate (19) a vacuum-deposited coating of non-uniform thickness or density characterised in that the period for which said surface is exposed to evaporated material at any particular point is varied depending on the density or thickness of the coating desired at said point.

2.    A method as claimed in Claim 1, wherein variation of the exposure period is achieved by inducing relative movement between a mask (23) and the substrate (19).

3.    A method as claimed in Claim 3, wherein said relative movement is reciprocal movement.

4.    A method as claimed in Claim 2 or 3, wherein said mask (23) is moved relatively to said substrate (19).

5.    A method as claimed in any one of Claims 2 to 4, wherein said substrate (19) and mask (23) are both moved relatively to the evaporation source.

6.    A method as claimed in any preceding Claim, wherein said period is constituted by an accumulation of exposures of short duration.

7.    Apparatus for controlling the thickness or density of a coating being produced on the surface of a substrate (19) by vacuum-deposition characterised in that said apparatus comprises drive means (24, 26) for imparting relative movement between holding means

- 2 -

(18) for holding said substrate (19) and masking means (23).

8. Apparatus as claimed in Claim 7, in which said drive means comprise a cam (24) and a cam follower (26) arranged to impart reciprocal relative movement between said holding means (18) and said masking means (23).

9. Apparatus as claimed in Claim 8, in which said cam (24) is fixed and said cam-follower (25) is arranged to revolve therearound, the arrangement being such that said masking means (23) are caused to revolve with said holding means (18) whilst being reciprocated relatively thereto.

10. Apparatus as claimed in Claim 8 or 9 in which said cam (24) has a sinusoidal profile so that the relative movement has a constant speed and the thickness of the coating deposited on said substrate varies linearly with distance in the direction of relative movement.

*FIG:1*

*FIG. 2*

## DOCUMENTS CONSIDERED TO BE RELEVANT

| Category | Citation of document with indication, where appropriate, of relevant passages | Relevant to claim |
|---|---|---|
| X | US - A - 3 759 221 (A.P. BRADFORD)<br><br>* The whole document *<br>-- | 1-4,<br>6-9 |
| X | FR - A - 1 020 308 (C.N.R.S.)<br><br>* The whole document *<br>-- | 1-4,6,7 |
|  | DE - B - 1 273 855 (F. CASSANAS)<br><br>* Claims 1,3; figure 2 *<br>-- | 1-7 |
|  | FR - A - 2 369 016 (MATRA)<br><br>* The whole document *<br>-- | 1-3,5-7 |
|  | US - A - 2 384 209 (T.W. SUKUMLYN)<br><br>* Claim 1; figures 4,6 *<br>-- | 1,2,4,7 |
|  | FR - A - 2 381 387 (MATRA)<br><br>* The whole document *<br>-- | 1,2,4-7 |
|  | FR - A - 805 066 (M.DUNOYER)<br><br>* Abstract: page 3, lines 85-104; page 4, lines 1-9; figure 5 * | 1,2,7 |

### CLASSIFICATION OF THE APPLICATION (Int. Cl. ³)

C 23 C 13/06
G 02 B 1/20
C 03 C 17/00

### TECHNICAL FIELDS SEARCHED (Int.Cl. ³)

C 23 C 13/06
        13/08
G 02 B 1/10

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 05.09.1980 | DEVISME |

EPO Form 1503.1  06.78

BAD ORIGINAL